Europäisches Patentamt

(19) European Patent Office

Office européen des brevets

(11) Numéro de publication: **0 109 914**

**A1**

(12) # DEMANDE DE BREVET EUROPEEN

(21) Numéro de dépôt: **83440054.1**

(51) Int. Cl.³: **G 01 R 19/155**

(22) Date de dépôt: **14.11.83**

(30) Priorité: **18.11.82 FR 8219476**

(43) Date de publication de la demande:
**30.05.84 Bulletin 84/22**

(84) Etats contractants désignés:
**AT BE CH DE GB IT LI LU NL SE**

(71) Demandeur: **Singer, Edouard**
**53, rue de Mulhouse**
**F-68790 Morschwiller-Le-Bas(FR)**

(72) Inventeur: **Singer, Edouard**
**53, rue de Mulhouse**
**F-68790 Morschwiller-Le-Bas(FR)**

(74) Mandataire: **Aubertin, François**
**Cabinet BUGNION PROPRIETE INDUSTRIELLE 4, rue de**
**Haguenau**
**F-67000 Strasbourg(FR)**

(54) **Dispositif de détection de la présence de tension sur les installations électriques.**

(57) Un dispositif comprenant un corps en matière isolante entouré par une enveloppe conductrice, dans lequel sont noyés un premier insert métallique relié à un point de contact extérieur et un second insert conducteur, entre lesquels se produisent des effets capacitifs, et des moyens reliés au second insert conducteur (5) permettant d'emmagasiner progressivement l'énergie et de la libérer rapidement pour générer une indication périodique. Ces moyens se présentent sous la forme d'un condensateur (10) alimenté par un courant redressé qui se décharge périodiquement dans un tube électroluminescent (11) chaque fois que la tension aux bornes du condensateur (10) atteint un seuil de déclenchement.

FIG.2

EP 0 109 914 A1

Dispositif de détection de la présence de tension sur les installations électriques.

L'invention concerne un dispositif de détection de la présence de tension sur des installations électriques haute tension, constitué par un corps en matière isolante entouré par une enveloppe conductrice, dans lequel sont noyés un premier insert métallique relié à un point de contact extérieur et un second insert conducteur, entre lesquels se produisent des effets capacitifs.

Elle trouvera, en particulier, son application dans le domaine de l'électricité, notamment pour contrôler la présence de courant sur les lignes haute tension.

Pour contrôler la présence de tension, on utilise habituellement une perche isolante équipée d'un dispositif de contact relié à un coffret de détection, renfermant un indicateur sonore ou visuel qui émet un signal en cas de présence de tension. Le dispositif de contact est relié à un diviseur de tension, nécessairement capacitif, étant donné que les tensions susceptibles d'être décelées, sont de l'ordre d'une ou de plusieurs dizaines de kV, et ce diviseur capacitif dont les capacités sont de l'ordre de quelques picofarads, est relié au détecteur proprement dit qui doit posséder une très grande impédance interne. En outre, l'armature extérieure du diviseur capacitif est mise à la terre afin de protéger l'opérateur au cours du test.

Le détecteur peut être constitué par un détecteur de tension, par exemple électronique, qui présente l'inconvénient de nécessiter une source d'énergie extérieure, par exemple une pile et qui est susceptible de tomber en panne en raison du grand nombre de composants qui le constituent et, en outre, cette solution est particulièrement onéreuse.

On pourrait également utiliser un élément passif, par exemple une ampoule à gaz rare, mais celle-ci présente une résistance interne trop faible pour être montée dans ce circuit. On retrouve le même inconvénient avec l'utilisation d'un tube électroluminescent, bien que celui-ci présente une très forte résistance interne pour des tensions inférieures au seuil de déclenchement, de l'ordre de quelques dizaines de volts.

La présente invention a pour but de remédier à ces inconvénients. L'invention, telle qu'elle est caractérisée dans les revendications, résout le problème consistant à créer un détecteur constitué par un circuit passif simple. Ce détecteur de la présence de tension sur des installations électriques haute tension constitué par un corps en matière isolante entouré par une enveloppe conductrice dans lequel sont noyés un premier insert métallique relié à un point de contact extérieur et un second insert conducteur, entre lesquels se produisent des effets capacitifs présente une résistance interne permettant d'emmagasiner progressivement l'énergie et de la libérer lorsqu'un seuil de déclenchement est atteint.

Les avantages obtenus grâce à cette invention consistent essentiellement en ceci que le dispositif ne nécessite aucune source d'énergie extérieure et il présente une très grande sécurité de fonctionnement par la simplicité de sa conception. Lorsque le seuil du déclenchement est atteint, l'énergie est alors libérée dans un composant passif habituel, par exemple un tube électroluminescent.

L'invention est exposée ci-après plus en détail à l'aide de dessins représentant seulement un mode d'exécution.

La figure 1 schématise un diviseur de tension capacitif.

La figure 2 représente un dispositif de détection selon l'invention pour un diviseur de tension capacitif.

La figure 3 schématise un détecteur amovible de tension selon l'invention.

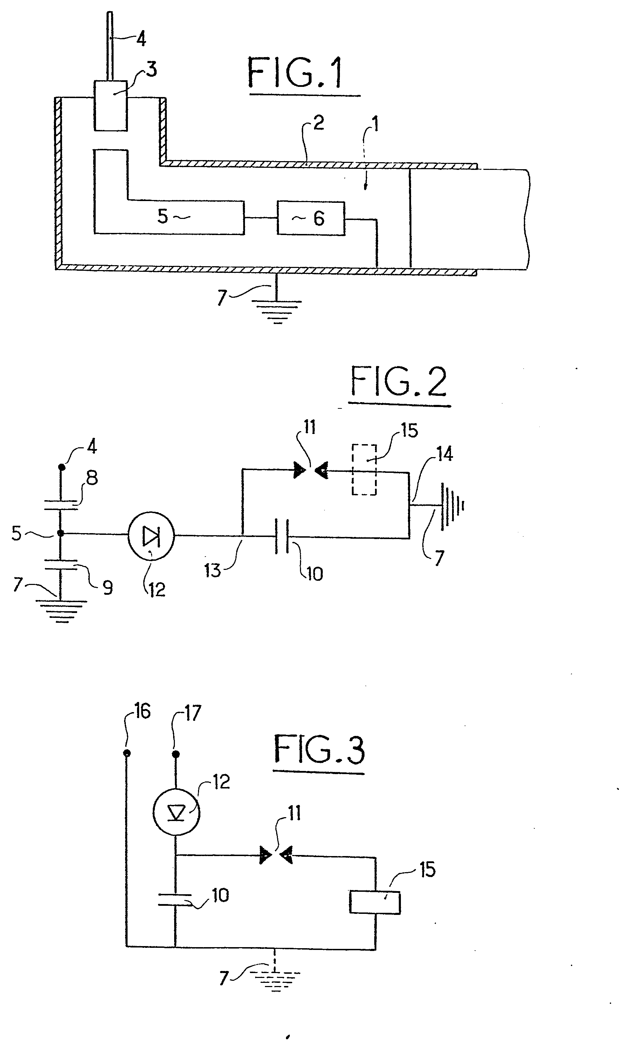

Le diviseur capacitif illustré à la figure 1 est constitué par un corps 1 en matière isolante, entouré par une enveloppe conductrice 2 qui sera avantageusement disposée à l'extrémité d'une perche isolante non représentée. Dans le corps 1 en matière isolante sont noyés, d'une part, un premier insert métallique 3 relié à un point de contact extérieur 4, et, d'autre part, un second insert conducteur 5. L'insert métallique 3 sera disposé à proximité de l'extrémité non enveloppée du corps 1 et il sera séparé de l'enveloppe conductrice 2 ainsi que du second insert conducteur 5 par de la matière isolante, et l'insert 5 est relié à la cellule de détection 6. De plus, l'enveloppe 2, qui constitue le blindage du diviseur de tension capacitif, est mise à la terre 7.

Lorsque le point de contact extérieur 4 est soumis à un champ électrique, le corps isolant 1 est le siège d'effets capacitifs, d'une part, entre les inserts 3 et 5, et, d'autre part, entre les inserts 3 et 5 et l'enveloppe conductrice 2. Cela est schématisé par les capacités 8 et 9 illustrées à la figure 2.

Le dispositif de détection de la présence de tension selon l'invention présente des moyens reliés à l'insert 5 du diviseur capacitif de tension qui permettent d'emmagasiner progressivement l'énergie et de la libérer rapidement pour générer une indication périodique.

Ces moyens sont illustrés schématiquement à la figure 2, et la cellule de détection 6 du diviseur capacitif, illustrée à la figure 1, se présente sous la forme d'un condensateur 10 alimenté par un courant redressé et d'un tube électroluminescent 11 qui est monté en parallèle avec le condensateur 10. Ce condensateur 10 se charge progressivement à chacune des alternances en emmagasinant l'énergie fournie à travers le point de contact extérieur 4. Cela se traduit par une augmentation progressive de la tension aux bornes de ce condensateur et lorsque cette tension atteint le seuil de déclenchement du tube électroluminescent 11, il se produit une décharge à travers celui-ci qui se traduit par l'éclairage du tube. La visualisation de la tension se présente sous la forme d'un éclat lumineux intense. Etant donné que la résistance interne de ce tube est très faible, l'énergie emmagasinée dans le condensateur 10, est libérée pratiquement instantanément et cela se manifeste par un éclat du tube.

Dès que toute l'énergie du condensateur 10 a été libérée dans le tube électroluminescent 11, le condensateur 10 se charge à nouveau progressivement jusqu'à atteindre à nouveau le seuil de déclenchement. Ainsi, la présence d'une tension au niveau du point de contact extérieur 4 se traduit par une indication périodique au niveau du tube électroluminescent 11.

Les moyens pour redresser le courant sont connus de l'Homme de l'Art et seront avantageusement constitués par une diode 12 dont les bornes seront reliées, d'une part à l'insert 5 et, d'autre part, à la borne commune 13 du condensateur 10 et du tube électroluminescent 11.

Ainsi, le faible courant disponible de l'ordre du micro-ampère, est redressé pour charger un condensateur dont les caractéristiques seront appropriées, et on branche aux bornes de ce condensateur un tube électroluminescent dans lequel le condensateur se décharge périodiquement chaque fois que la tension de déclenchement est atteinte, en produisant un éclat lumineux intense. La période, entre deux éclats consécutifs, peut être de l'ordre de 1 seconde.

L'autre borne commune 14 du condensateur 10 et du tube électroluminescent 11, est reliée à l'enveloppe conductrice 2 du diviseur capacitif, la mettant ainsi à la terre 7.

La puissance instantanée fournie par le condensateur 10, peut également alimenter un générateur acoustique 15 monté en série avec le tube électroluminescent 11. Ce générateur acoustique 15 est représenté en pointillé sur la figure 2. Ainsi, au signal lumineux produit par le tube, on peut adjoindre un dispositif sonore, engendrant un signal acoustique intermittent.

La figure 3 illustre un dispositif amovible selon l'invention, celui-ci n'étant pas relié à demeure à un diviseur de tension capacitif comme dans le cas de la figure 2. On y retrouve tous les éléments décrits précédemment, en particulier, une diode 12 qui alimente en courant redressé un condensateur 10, monté en parallèle avec un tube électroluminescent 11, éventuellement en séries avec un générateur acoustique 15, dont la seconde borne commune est reliée à un blindage 16, lui-même pouvant être mis à la terre 7. Ce détecteur amovible peut être relié à diverses sources d'alimentation indépendantes, en réalisant, d'une part, la connection au niveau de la borne 17 de la diode 12 et, d'autre part, au niveau du blindage 16 du détecteur.

Revendications

1. Dispositif de détection de la présence de tension sur des installations électriques haute tension, constitué par un corps (1) en matière isolante, entouré par une enveloppe (2) conductrice, dans lesquels sont noyés un premier insert métallique (3) relié à un point de contact extérieur (4) et un second insert conducteur (5), entre lesquels se produisent des effets capacitifs, caractérisé par le fait qu'il présente des moyens reliés au second insert conducteur (5), qui permettent d'emmagasiner progressivement l'énergie et de la libérer rapidement pour générer une indication périodique.

2. Dispositif de détection selon la revendication 1, caractérisé par le fait que lesdits moyens se présentent sous la forme d'un condensateur (10) alimenté par un courant redressé et d'un tube électroluminescent (11) monté en parallèle avec le condensateur (10) qui visualise par un éclairage intermittent la présence de tension.

3. Dispositif de détection selon la revendication 2, caractérisé par le fait que l'une des bornes communes du condensateur (10) et du tube électroluminescent (11) est reliée à l'enveloppe conductrice (2) du corps (1) en matière isolante.

4. Dispositif de détection selon l'une quelconque des revendications 2 ou 3, caractérisé par le fait que le tube électroluminescent (11) est monté en association avec un générateur acoustique (15) qui engendre un signal acoustique intermittent.

5. Dispositif de détection selon l'une quelconque des revendications précédentes, caractérisé par le fait qu'il peut être porté par une perche isolante.

0109914

"1/1"

FIG.1

FIG.2

FIG.3

Office européen
des brevets

**RAPPORT DE RECHERCHE EUROPEENNE**

Numéro de la demande

EP  83 44 0054

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | EP-A-0 061 983  (M. SINGER)<br>* Figure 1; abrégé *<br><br>--- | 1 | G 01 R  19/155 |
| A | DE-A-2 600 253  (RAUSCH & PAUSCH)<br>*  Figure 5; dernier paragraphe - page 8 *<br><br>--- | 1 | |
| A | FR-A-2 331 795  (CEM)<br>*  Figure 2; page 2, lignes 16-22 *<br><br>--- | 1 | |
| A | US-A-4 152 643  (E.O. SCHWEITZER Jr.)<br>* Figure 1; colonne 2, ligne 64 - colonne 3, ligne 8 *<br><br>----- | 1 | |

**DOMAINES TECHNIQUES RECHERCHES (Int. Cl. 3)**

G 01 R

Le présent rapport de recherche a été établi pour toutes les revendications

| Lieu de la recherche<br>LA HAYE | Date d'achèvement de la recherche<br>02-02-1984 | Examinateur<br>MIELKE W |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82